# EUROPÄISCHE PATENTSCHRIFT

(11) **EP 3 712 972 B1**
(45) Veröffentlichungstag und Bekanntmachung des Hinweises auf die Patenterteilung: **08.06.2022**
(21) Anmeldenummer: 20163354.2
(22) Anmeldetag: 16.03.2020
(51) Int. Cl.: H01L 41/053, H01L 41/107, H05H 1/24

(54) **VORRICHTUNG UND BAUELEMENT ZUR ERZEUGUNG EINER HOHEN SPANNUNG ODER HOHEN FELDSTÄRKE**
DEVICE AND COMPONENT FOR GENERATING A HIGH VOLTAGE OR HIGH FIELD STRENGTH
DISPOSITIF ET COMPOSANT DE GÉNÉRATION D'UNE HAUTE TENSION OU D'UNE INTENSITÉ DE CHAMP ÉLEVÉE

(30) Priorität: 21.03.2019 DE 102019107238
(43) Veröffentlichungstag der Anmeldung: 23.09.2020
(73) Patentinhaber: Relyon Plasma GmbH, 93055 Regensburg (DE)
(72) Erfinder: NETTESHEIM, Stefan, 93051 Regensburg (DE); SHESTAKOV, Anatoly, 93053 Regensburg (DE)
(74) Vertreter: Reichert & Lindner Partnerschaft Patentanwälte

(56) Entgegenhaltungen:
- WO-A2-2017/207654
- DE-A1- 3 927 406
- DE-A1-102014 110 405
- DE-A1-102016 102 585
- DE-T2- 60 033 247
- DE-U1-212018 000 015
- US-A1- 2016 120 016
- ANDREW BENWELL ET AL: "Flashover Prevention of High Voltage Piezoelectric Transformers by Thin Film Encapsulation", IEEE TRANSACTIONS ON PLASMA SCIENCE, IEEE SERVICE CENTER, PISCATAWAY, NJ, US, Bd. 38, Nr. 12, 1. Dezember 2010 (2010-12-01), Seiten 3455-3459, XP011338404, ISSN: 0093-3813, DOI: 10.1109/TPS.2010.2079957
- TERANISHI K ET AL: "A novel generation method of dielectric barrier discharge and ozone production using a piezoelectric transformer", JAPANESE JOURNAL OF APPLIED PHYSICS, JAPAN SOCIETY OF APPLIED PHYSICS, JP, Bd. 43, Nr. 9B, 1. September 2004 (2004-09-01), Seiten 6733-6739, XP002432140, ISSN: 0021-4922, DOI: 10.1143/JJAP.43.6733

## Beschreibung

Die vorliegende Erfindung betrifft eine Vorrichtung zur Erzeugung einer hohen Spannung oder hohen Feldstärke. Die Vorrichtung umfasst einen piezoelektrischen Transformator, der einen Eingangsbereich und einen Ausgangsbereich definiert. Eine Ansteuerelektronik ist zur Versorgung des piezoelektrischen Transformators mit Wechselspannung vorgesehen. Mit einer Kontaktierung an einer ersten Seitenfläche des Eingangsbereichs und einer Kontaktierung an einer zweiten Seitenfläche des Eingangsbereichs des piezoelektrischen Transformators wir die Wechselspannung angelegt.

Ferner betrifft die gegenwärtige Erfindung ein Bauelement zur Erzeugung einer hohen Spannung oder hohen Feldstärke.

Aus dem Stand der Technik sind elektrokeramische Bauteile, beispielsweise piezoelektrische Transformatoren (PT), bekannt, wie zum Beispiel aus dem US-Patent US 2,830,274 A von 1958 nach Charles A. Rosen. Ein piezoelektrischer Transformator ist ein elektromechanischer Resonanztransformator, der eine Kombination aus dem inversen Piezoeffekt (Anregung) und direktem Piezoeffekt (Spannungserzeugung) nutzt, um eine Eingangsspannung mit einem gegebenen Übersetzungsverhältnis in eine Ausgangsspannung zu wandeln. Frequenz und Übersetzungsverhältnis werden dabei durch die Abmessungen und die elektromechanischen Materialeigenschaften bestimmt. Typischerweise werden piezoelektrische Transformatoren mit einem elektrischen Treiberbaustein betrieben, der eine elektrische Anregung in einem geeigneten Resonanz-Modem aufprägt. Anwendungsbereiche liegen, beispielsweise, in der Erzeugung einer Hochspannung für die Versorgung von Leuchtröhren. Piezoelektrische Transformatoren erzeugen hohe elektrische Felder, die in der Lage sind, Gase durch elektrische Anregung zu ionisieren.

Mit der Entwicklung von speziellen Ferroelektrika (z. B. Blei-Zirkonat-Titanat (PZT)) und dem schichtartigen Aufbau als Multilayer, konnten sehr hohe Übersetzungsverhältnisse erreicht werden, die bis hin zur spontanen Gasentladung an der Hochspannungsseite reichen. Dieser Effekt kann z. B. zum Aufbau von effizienten kalten Entladungsquellen, Ozongeneratoren und Ionisatoren genutzt werden (siehe WO 2007/006298 A2 oder H. Itoh, K. Teranishi and S. Suzuki, Plasma Sources, Sci. and Tech. 15 (2006) S51)

Durch die Ionisierung der Gase wird ein piezoelektrisch gezündetes Mikroplasma erzeugt. Dieser Prozess ist mit Eigenschaften, die mit einer dielektrischen Barriereentladung vergleichbar sind, und wie sie, beispielsweise, im deutschen Patent DE 10 2013 100 617 B4 beschrieben sind. Hier ist eine Vorrichtung zur Erzeugung eines Plasmas mit einer Steuerschaltung offenbart. Die Steuerschaltung ist, zur Anregung eines piezoelektrischen Transformators, mit diesem elektrisch verbunden. Ebenso ist ein Handgerät offenbart, das die Vorrichtung verwendet. Der piezoelektrische Transformator ist aus mehreren Schichten aufgebaut. Auf einer Platine ist die Steuerschaltung realisiert und der piezoelektrische Transformator ist mit einem Bereich eines ersten Endes über der Platine gehaltert. An einem zweiten freien Ende des piezoelektrischen Transformators liegt eine Hochspannung an, wobei das Plasma bei Atmosphärendruck erzeugt wird.

Die deutsche Patentanmeldung DE 10 2017 105 410 A1 betrifft einen Plasmagenerator zur Erzeugung von nichtthermischem Atmosphärendruck-Plasma mit einem piezoelektrischen Transformator. Der piezoelektrische Transformator ist in Längsrichtung in einen Eingangsbereich und einen Ausgangsbereich unterteilt. An den Eingangsbereich ist eine Wechselspannung anlegbar, wobei der Ausgangsbereich ein piezoelektrisches Material aufweist, das, bei an den Eingangsbereich angelegter Wechselspannung, den Aufbau eines elektrischen Feldes bewirkt. Der piezoelektrische Transformator weist eine ausgangsseitige Stirnseite auf, die vom Eingangsbereich weg weist. Der Plasmagenerator ist derart ausgestaltet, dass nur dann, eine zur Zündung eines nichtthermischen Atmosphärendruck-Plasmas, ausreichende Leistung an den Eingangsbereich des piezoelektrischen Transformators angelegbar ist, wenn vor der ausgangsseitigen Stirnseite eine Last angeordnet ist.

Die deutsche Patentanmeldung DE 10 2017 105 430 A1 betrifft eine Vorrichtung zur Erzeugung eines nichtthermischen Atmosphärendruck-Plasmas. Es ist ein erstes Gehäuse vorgesehen, in dem ein piezoelektrischer Transformator angeordnet ist. In einem zweiten Gehäuse ist eine Ansteuerschaltung vorgesehen, die dazu ausgestaltet ist, eine Eingangsspannung an den piezoelektrischen Transformator anzulegen. Ferner ist ein Wirkraum offenbart, der die Vorrichtung und ein dichtes Gasvolumen oder ein undichtes Gasvolumen aufweist.

Das US-Patent US 6,333,589 B1 offenbart einen laminierten piezoelektrischen Transformator, der ein Durchgangsloch aufweist. Das Durchgangsloch ist in dem laminierten piezoelektrischen Transformator an einer zentralen Position gebildet, die ein Vibrationsknoten des laminierten piezoelektrischen Transformators wird. Ein Stützelement ist in das Durchgangsloch eingesetzt und mit dem Durchgangsloch verbunden. Durch ein Bindemittel wird eine Halterung des laminierten piezoelektrischen Transformators erreicht.

Die deutsche Offenlegungsschrift DE 39 27 406 A1 offenbart einen piezokeramischen Transformator. Die Piezokeramik umfasst Elektroden, die zusammen mit der Piezokeramik in einer Silikonkautschuk-Vergußmasse mit einer Shore-Härte ≦ 40 eingegossen sind. Die Vergussmasse ist von einer verlorenen Schalung teilweise umgeben.

Die Gebrauchsmusterschrift DE 21 2018 000 015 U1 beschreibt eine Vorrichtung zur Erzeugung eines nicht-thermischen Atmosphärendruck-Plasmas. Die Vorrichtung umfasst ein erstes Gehäuse, in dem ein piezoelektrischer Transformator angeordnet ist. In einem zweiten Gehäuse ist eine Ansteuerschaltung angeordnet, die dazu ausgestaltet ist, eine Eingangsspannung an den piezoelektrischen Transformator anzulegen. Das erste Gehäuse weist zur Vernichtung eines Reizgases eine Beschichtung auf. Ebenso ist im Gehäuse eine Öffnung vorgesehen, durch die das Prozessgas austreten kann.

Die US-Patentanmeldung US 2016/0120016 A1 offenbart einen kompakten piezoelektrischen Partikelemitter mit geringer Leistung zur Emission von Partikeln, wie Röntgenstrahlen und Neutronen. Ein piezoelektrischer Transformatorkristall empfängt eine Eingangsspannung an einem Eingangsende und erzeugt eine höhere Ausgangsspannung an einer Ausgangselektrode, die an einem Ausgangsende angeordnet ist. Der Emitter befindet sich im Vakuum und die Ausgangsspannung erzeugt ein elektrisches Feld. Eine geladene Teilchenquelle ist relativ zu einem Target so positioniert, dass geladene Teilchen von der geladenen Teilchenquelle durch das elektrische Feld in Richtung des Targets beschleunigt werden. Durch die Wechselwirkung zwischen den beschleunigten geladenen Teilchen und dem Target, werden Röntgenstrahlen und Neutronen emittiert.

Die Übersetzung DE 600 33 247 T2 der europäischen Patentschrift EP 1 056 162 B1 offenbart eine Vorrichtung zum Steuern eines elektrischen Feldes, wie z.B. an einer Verbindung eines Hochspannungskabels. Hierzu ist eine kapazitive Feldsteuerung vorgesehen, die mehrere kapazitive Schichten umfasst, die im Wesentlichen konzentrisch zwischen einem inneren stromführenden Leiter und einem äußeren Erdpotential angeordnet sind.

Es ist ferner bekannt, dass piezoelektrische Transformatoren einen sehr hohen Spannungshub (Übersetzungsverhältnis) liefern und hervorragend geeignet sind, bei geringem Aufwand kostengünstig elektrische Wechselspannungen mit hoher Amplitude zu erzeugen. Darüber hinaus können solche piezoelektrischen Transformatoren auch genutzt werden, um eine direkte elektrische Gasentladung an der Hochspannungsseite zu zünden. Dabei treten in allen Fällen diverse technische Schwierigkeiten auf, wie nachfolgend beschrieben. Die mechanische Schwingung des elektromechanischen Wandlers darf weder stark gedämpft noch behindert werden, da sonst die Güte und Effizienz bezüglich der Umwandlung sinken und das Bauteil bzw., die Vorrichtung mit dem piezoelektrischen Transformator, beschädigt werden kann. Ferner muss die Verlustleistung aus dem schwingenden Bauteil abgeführt werden. Des Weiteren muss der Anregungsteil sicher mit dem Anregungssignal verknüpft sein. Darüber hinaus ist es wünschenswert, dass das Bauteil bzw. die Vorrichtung mit dem piezoelektrischen Transformator, vor Umwelteinflüssen, wie beispielsweise Feuchte, Schmutz etc., geschützt wird und von externen mechanischen Stößen entkoppelt ist.

Ein weiteres Problem stellen parasitäre Entladungen dar, die von der Hochspannungszone des elektrokeramischen Bauteils, beispielsweise, eines piezoelektrischen Transformators, unkontrolliert gegen das Gehäuse der Vorrichtung mit dem elektrokeramischen Bauteil oder andere Objekte in der Umgebung der Vorrichtung zünden.

Der Erfindung liegt somit die Aufgabe zugrunde, eine Vorrichtung zur Erzeugung einer hohen Spannung oder hohen Feldstärke zu schaffen, wobei der piezoelektrische Transformator der Vorrichtung ein hohes Übersetzungsverhältnis, eine hohe Effizienz aufweist und dabei gleichzeitig geschützt ist gegen Teilentladungen und somit eine lange Lebensdauer aufweist.

Die obige Aufgabe wird durch eine Vorrichtung zur Erzeugung einer hohen Spannung oder hohen Feldstärke gelöst, die die Merkmale des Anspruchs 1 umfasst.

Eine weitere Aufgabe der Erfindung ist, ein Bauelement zur Erzeugung einer hohen Spannung oder hohen Feldstärke zu schaffen, wobei der piezoelektrische Transformator des Bauteils ein hohes Übersetzungsverhältnis, eine hohe Effizienz aufweist und dabei gleichzeitig geschützt ist gegen Teilentladungen, Schmutzablagerung, mechanische Belastung und Überhitzung und somit eine lange Lebensdauer aufweist.

Die obige Aufgabe wird durch ein Bauelement zur Erzeugung einer hohen Spannung oder hohen Feldstärke gelöst, das die Merkmale des Anspruchs 11 umfasst.

Die erfindungsgemäße Vorrichtung zur Erzeugung einer hohen Spannung oder hohen Feldstärke umfasst einen piezoelektrischen Transformator, der einen Eingangsbereich und einen Ausgangsbereich ausgebildet hat. Der piezoelektrische Transformator ist entlang seiner Längsrichtung von einer zylinderförmigen, dielektrischen Hülse umgeben. Eine Ansteuerelektronik ist zur Versorgung des piezoelektrischen Transformators mit Wechselspannung mit einer Kontaktierung an einer ersten Seitenfläche des Eingangsbereichs und mit einer Kontaktierung an einer zweiten Seitenfläche des Eingangsbereichs über elektrische Leitungen verbunden. Die Vorrichtung umfasst ein Mittel, das in einem Bereich der zylinderförmigen und dielektrischen Hülse, ausgehend von einer ausgangsseitigen Stirnfläche des piezoelektrischen Transformators, vorgesehen ist. Das Mittel bzw. der Bereich erstreckt sich zumindest teilweise in Längsrichtung der Hülse bzw. entlang des Ausgangsbereichs des piezoelektrischen Transformators. Das Mittel ist derart ausgestaltet, dass die ausgangsseitige Stirnfläche des piezoelektrischen Transformators abdeckt ist. Durch das Mittel ist in einem Raum des Bereichs zwischen dem piezoelektrischen Transformator und einer Innenwand der dielektrischen Hülse eine im Wesentlichen symmetrische Feldverteilung ausgebildet. Das Mittel bewirkt, dass, bei einem äußeren Einfluss, die Feldverteilung derart beeinflusst wird, dass eine Zündfeldstärke im Raum des Bereichs vermieden ist.

Die unterschiedlichen Ausgestaltungen des Mittels haben den Vorteil, dass schädliche parasitäre Entladungen, die beim piezoelektrischen Transformator auf kleinem Raum durch sehr hohe Potentialdifferenzen hervorgerufen werden können, vermieden werden. Diese parasitären Entladungen können die Effizienz des Transformationsprozesses mindern, oder sogar zur Schädigung des piezoelektrischen Bauteils führen. Auch eine stark asymmetrische Feldverteilung belastet das piezoelektrische Bauteil und mindert die Effizienz der Transformation. All dies kann durch das erfindungsgemäße Mittel verhindert werden.

Erfindungsgemäß kann, gemäß einer möglichen Ausführungsform, das Mittel eine topfförmige Kappe sein. Die Kappe umfasst einen Boden und einen radial umlaufenden Rand. Der Boden deckt dabei die ausgangsseitige Stirnfläche des piezoelektrischen Transformators ab. Der radial umlaufende Rand der Kappe erstreckt sich in Richtung der Längsachse und somit entlang des Bereichs, der für die symmetrische Feldverteilung im Gehäuse der Vorrichtung zuständig ist.

Erfindungsgemäß treten die Entladung direkt am stirnseitigen offenen Ende, also der Stirnfläche, des piezoelektrischen Transformators auf. Durch das Mittel ist der piezoelektrische Transformator gegenüber seitlichen (radialen) Entladungen oder asymmetrischen Entladungen nicht mehr empfindlich.

Gemäß einer möglichen Ausführungsform ist die topfförmige Kappe derart an einem ausgangsseitigen Ende der zylinderförmigen Hülse abgebracht, dass der radial umlaufende Rand der Kappe die zylinderförmige Hülse in diesem Bereich umschließt. Der Boden der Kappe liegt der ausgangsseitigen Stirnfläche des piezoelektrischen Transformators gegenüber. Die topfförmige Kappe verschließt das ausgangsseitige Ende der zylinderförmigen Hülse. Die hat den Vorteil, dass im Bereich der topfförmigen Kappe eine im Wesentlichen symmetrische Feldverteilung vorherrscht, die auch von außen her nicht derart beeinflusst werden kann, dass eine Zündung eines Plasmas im Innenraum der Hülse auftritt.

Gemäß einer weiteren Ausführungsform der Erfindung kann, eine weitere Kappe an einem eingangsseitigen Ende der zylinderförmigen Hülse abgebracht sein. Ein radial umlaufender Rand der weiteren Kappe umschließt die zylinderförmige Hülse und der Boden einer weiteren Kappe deckt eine eingangsseitige Stirnfläche des piezoelektrischen Transformators ab bzw. liegt ihr gegenüber. Die weitere Kappe verschließt somit das eingangsseitige Ende der zylinderförmigen Hülse. Mittels der weiteren Kappe ist der piezoelektrische Transformator in der Hülse gegen Verschmutzungen, Berührungen und/oder Beschädigungen geschützt.

Gemäß einer möglichen Ausführungsform der Erfindung kann das Mittel aus der topfförmigen Kappe bestehen, die derart an einem ausgangsseitigen Ende der zylinderförmigen Hülse abgebracht ist, dass der radial umlaufende Rand der Kappe im dielektrischen Material der zylinderförmigen Hülse im Bereich eingebettet ist. Der Boden der Kappe liegt dann der ausgangsseitigen Stirnfläche des piezoelektrischen Transformators gegenüber. Die topfförmige Kappe verschließt das ausgangsseitige Ende der zylinderförmigen Hülse.

Gemäß einer möglichen weiteren Ausführungsform der Erfindung, kann das Mittel die topfförmige Kappe und mehrere kapazitive Elemente umfassen, die im Material der zylinderförmigen Hülse im Bereich eingebettet sind. Die topfförmige Kappe ist an einem ausgangsseitigen Ende der zylinderförmigen Hülse abgebracht, so dass der radial umlaufende Rand der Kappe im dielektrischen Material der zylinderförmigen Hülse im Bereich eingebettet ist. Der Boden der Kappe liegt der ausgangsseitigen Stirnfläche des piezoelektrischen Transformators gegenüber. Die topfförmige Kappe verschließt das ausgangsseitige Ende der zylinderförmigen Hülse.

Gemäß einer noch weiteren möglichen Ausführungsform der Erfindung, kann das Mittel die topfförmige Kappe und mehrere resistive und/oder kapazitive Füller umfassen. Mit den Füllern ist das Material der zylinderförmigen Hülse im Bereich gefüllt. Die topfförmige Kappe ist, wie bei allen Ausführungsformen, am ausgangsseitigen Ende der zylinderförmigen Hülse abgebracht, so dass der radial umlaufende Rand der Kappe im dielektrischen Material der zylinderförmigen Hülse im Bereich eingebettet ist. Der Boden der Kappe liegt der ausgangsseitigen Stirnfläche des piezoelektrischen Transformators gegenüber. Die topfförmige Kappe verschließt das ausgangsseitige Ende der zylinderförmigen Hülse.

Gemäß einer ebenfalls möglichen Ausführungsform der Erfindung kann das Mittel die topfförmige Kappe sein, die derart an einem ausgangsseitigen Ende der zylinderförmigen Hülse abgebracht ist, so dass der radial umlaufende Rand der Kappe im dielektrischen Material der zylinderförmigen Hülse im Bereich eingebettet ist. Der radial umlaufende Rand ist, vom Boden ausgehend, aufgeweitet ausgebildet und der Boden der Kappe kann mit der ausgangsseitigen Stirnseite des piezoelektrischen Transformators über ein dauerelastisches Element gekoppelt sein. Die topfförmige Kappe verschließt das ausgangsseitige Ende der zylinderförmigen Hülse.

Gemäß einer möglichen Ausführungsform der Erfindung, kann die zylinderförmige Hülse an einer Außenwand, zumindest im Eingangsbereich, eine leitende Umhüllung aufweisen. Die Umhüllung ist mit dem Erdpotential verbunden.

Gemäß einer bevorzugten Ausführungsform wird aufgrund der hohen Spannung oder hohen Feldstärke ein Plasma nach dem Mittel gebildet, das auf die ausgangsseitige Stirnfläche des piezoelektrischen Transformators folgt. Das Plasma wird außerhalb der zylinderförmigen und dielektrischen Hülse ausgebildet.

Die Besonderheit des piezoelektrischen Transformators ist nun, dass sich eine kontinuierlich ansteigende Potentialamplitude (in Bezug auf Erdpotential) in axialer Richtung innerhalb der Hülse aufbaut. Gegenüber symmetrischen Teilentladungen in axialer Richtung ist der piezoelektrische Transformator robust. Die symmetrischen Teilentladungen sind sogar, im Fall der Verwendung des piezoelektrischen Transformators, als kalte Entladungsquellen erwünscht. In diesem Fall tritt eine Entladung direkt am stirnseitigen offenen Ende des piezoelektrischen Transformators auf. Allerdings ist der piezoelektrische Transformator gegenüber seitlichen (radialen) Entladungen oder asymmetrischen Entladungen sehr empfindlich.

Bereits der Einbau in eine Hülse, die Halterung des piezoelektrischen Transformators oder Spuren von Staub oder Verschmutzungen auf der Oberfläche des piezoelektrischen Transformators können solche schädlichen parasitären Entladungen zünden und den piezoelektrischen Transformator durch elektromechanischen Bruch beschädigen. All dies kann durch das erfindungsgemäße Bauelement verhindert werden.

Das erfindungsgemäße Bauelement dient zur Erzeugung einer hohen Spannung oder hohen Feldstärke. Der piezoelektrische Transformator ist in eine zylindrische, dielektrische Hülse eingesetzt. Der piezoelektrische Transformator ist in axialer Richtung, konzentrisch, in der Hülse angeordnet. Eine Kappe ist an einem ausgangsseitigen Ende der Hülse derart angebracht, dass eine ausgangsseitige Stirnfläche des piezoelektrischen Transformators an der Kappe anliegt. Eine weitere Kappe ist an einem eingangsseitigen Ende der Hülse derart angebracht, dass eine eingangsseitige Stirnfläche des piezoelektrischen Transformators an der weiteren Kappe anliegt. In der Kappe und der weiteren Kappe ist jeweils ein dauerelastisches Element vorgesehen, in denen der piezoelektrische Transformator gehaltert ist.

Durch die Kappe und die weitere Kappe ist der piezoelektrische Transformator vollkommen in der Hülse eingeschlossen. Der piezoelektrische Transformator ist somit gegen Staub oder Verschmutzungen auf der Oberfläche des piezoelektrischen Transformators geschützt. Da es sich bei dem piezoelektrischen Transformator um ein elektromechanisches schwingendes Bauteil handelt muss der piezoelektrische Transformator in geeigneter Weise so gelagert werden, so dass die Schwingung, mechanisch, nicht übermäßig gestört oder gedämpft wird. Hierzu sind die dauerelastischen Elemente in der Kappe und der weiteren Kappe vorgesehen. Die mechanische Aufhängung bzw. Halterung kann dabei mit der elektrischen Feldsteuerung kombiniert werden. Die Kühlung des piezoelektrischen Transformators kann z. B. mit metallischen Kappen optimiert werden.

Das Bauelement weist zwei elektrische Leitungen auf, die mit einer jeden Kontaktierung des piezoelektrischen Transformators verbunden sind. Die elektrischen Leitungen werden durch die dielektrische Hülse des Bauelements zu der Kontaktierung geführt.

Die dielektrische Hülse hat jeweils, beidseitig, einen radial umlaufenden Absatz ausgebildet, an dem die Kappe bzw. die weitere Kappe anliegt. Durch die Absätze kann somit eine definierte Positionierung der Kappe bzw. der weiteren Kappe an der Hülse bereitgestellt werden. Dies hat den Vorteil, dass der piezoelektrische Transformator sicher und definiert in der Hülse des Bauteils gehaltert wird. Auch kommt es bei der Montage des Bauelements nicht zu einer Beschädigung des piezoelektrischen Transformators.

In der dielektrischen Hülse ist mindestens ein Durchgang ausgebildet, über den ein Druck-, Temperatur- oder Feuchtigkeitsausgleich durchführbar ist. Der mindestens eine Durchgang ist derart ausgebildet, dass eine Eindringen von Schmutz oder Fremdkörpern, von außen, in die Hülle nicht möglich ist.

Gemäß einer bevorzugten Ausführungsform des erfindungsgemäßen Bauelements kann ein Plasma nach der Kappe, die am ausgangsseitigen Ende der Hülse und auf die ausgangsseitige Stirnfläche des piezoelektrischen Transformators folgt, außerhalb der zylinderförmigen und dielektrischen Hülse ausgebildet werden.

Auch in der Hochspannungstechnik sind verschiedene Lösungsansätze zur Optimierung der Feldverteilung durch Feldsteuermaßnahmen bekannt. Dabei dient die gezielte Feldsteuerung typischerweise dazu, die lokale elektrische Feldstärken so weit zu senken, dass die elektrischen Festigkeiten der Isoliermaterialien, Luftstrecken und der Grenzflächen, nicht bis zum elektrischen Durchschlagen überschritten wird.

Je nach System und Spannungsart (Gleich- oder Wechselspannung) stehen verschiedene Methoden zur Entschärfung der Feldverteilung zur Verfügung. Es kann z. B. eine geometrische Steuerung durch die Formgebung von Elektrodenkonturen erreicht werden. Eine kapazitive Steuerung kann durch leitfähige Steuerbeläge mit kapazitiv bestimmter Spannungsaufteilung bei Wechselspannungen erreicht werden. Eine refraktive Steuerung kann durch hochpermittive dielektrische Isolierstoffe bei Wechselspannungen erreicht werden. Eine resistive Steuerung kann durch restleitfähige Steuerbeläge für Gleich- und Wechselspannungen erreicht werden.

Die Besonderheit des piezoelektrischen Transformators ist nun, dass eine kontinuierlich ansteigende Potentialamplitude (in Bezug auf Erdpotential) sich in axialer Richtung aufbaut. Gegenüber symmetrischen Teilentladungen in axialer Richtung ist der piezoelektrische Transformator robust und diese kann sogar, im Fall der Verwendung des piezoelektrischen Transformators, als kalte Entladungsquelle erwünscht sein. In diesem Fall tritt eine Entladung direkt am stirnseitigen offenen Ende des piezoelektrischen Transformators auf. Allerdings ist der piezoelektrische Transformator gegenüber seitlichen (radialen) Entladungen oder asymmetrischen Entladungen sehr empfindlich.

Es wurde nun überraschenderweise beobachtet, dass, wenn ein an der Hochspannungsseite des Bauelements bzw. der Vorrichtung, ein Mittel zur Feldsteuerung vorgesehen ist, das Mittel das Bauelement bzw. die Vorrichtung bei hoher Effizienz vollständig stabilisiert. Der Vorteil ist, dass bei dem Bauteil bzw. der Vorrichtung, eine geringe parasitäre Zündneigung in radialer Richtung auftritt. Ebenso ergibt sich eine geringe Abhängigkeit von der elektrischen Umgebung. Es existiert eine symmetrische Feldverteilung zwischen dem piezoelektrischen Transformator und der inneren Wand des Gehäuses bzw. der Hülle. Schließlich kommt es, gemäß der Erfindung, zu einer Minimierung der dielektrischen Verluste und kapazitiven Last über die Oberfläche des Bauelements.

Im Folgenden sollen Ausführungsbeispiele die Erfindung und ihre Vorteile anhand der beigefügten Figuren näher erläutern. Die Größenverhältnisse in den Figuren entsprechen nicht immer den realen Größenverhältnissen, da einige Formen vereinfacht und andere Formen zur besseren Veranschaulichung vergrößert im Verhältnis zu anderen Elementen dargestellt sind. Dabei zeigen:
- **Figur 1**: einen piezoelektrischen Transformator aus dem Stand der Technik in einer perspektivischen Ansicht,
- **Figur 2**: eine graphische Darstellung der Ausbildung der Hochspannung an der ausgangsseitigen Stirnfläche des piezoelektrischen Transformators;
- **Figur 3**: eine schematische Darstellung einer herkömmlichen Beschaltung des piezoelektrischen Transformators;
- **Figur 4**: eine schematische Darstellung der Feldverteilung des elektrischen Feldes bei einem äußeren Einfluss auf die herkömmliche Anordnung des piezoelektrischen Transformators in einer Hülse;
- **Figur 5**: eine schematische Darstellung der Feldverteilung des elektrischen Feldes bei einem äußeren Einfluss auf die erfindungsgemäße Anordnung des piezoelektrischen Transformators in einer Hülse;
- **Figur 6**: eine schematische Darstellung der Vorrichtung zur Erzeugung einer hohen Spannung oder hohen Feldstärke, wobei im Ausgangsbereich ein Mittel vorgesehen ist, das zur kapazitiven Feldsteuerung geeignet ist;
- **Figur 7**: eine schematische Darstellung der Vorrichtung zur Erzeugung einer hohen Spannung oder hohen Feldstärke, wobei im Ausgangsbereich ein Mittel vorgesehen ist, das zur refraktiven Feldsteuerung mit einem hochrefraktiven Dielektrikum geeignet ist;
- **Figur 8**: eine schematische Darstellung der Vorrichtung zur Erzeugung einer hohen Spannung oder hohen Feldstärke, wobei im Ausgangsbereich ein Mittel vorgesehen ist, das zur resistiven und/oder kapazitiven Feldsteuerung über ein Füllgrad in der Hülse geeignet ist;
- **Figur 9**: eine schematische Darstellung der Vorrichtung zur Erzeugung einer hohen Spannung oder hohen Feldstärke, wobei im Ausgangsbereich ein Mittel vorgesehen ist, das zur geometrischen Feldsteuerung geeignet ist;
- **Figur 10**: eine perspektivische Ansicht eines Bauelements zur Erzeugung einer hohen Spannung oder hohen Feldstärke;
- **Figur 11**: eine Schnittansicht des Bauelements zur Erzeugung einer hohen Spannung oder hohen Feldstärkeentlang der in Figur 10 gezeigten Schnittlinie A-A; und
- **^{Fi}gur 12**: eine perspektivische Schnittansicht des Bauelements zur Erzeugung einer hohen Spannung oder hohen Feldstärke.

Für gleiche oder gleich wirkende Elemente der Erfindung werden identische Bezugszeichen verwendet. Ferner werden der Übersicht halber nur Bezugszeichen in den einzelnen Figuren dargestellt, die für die Beschreibung der jeweiligen Figuren erforderlich sind.

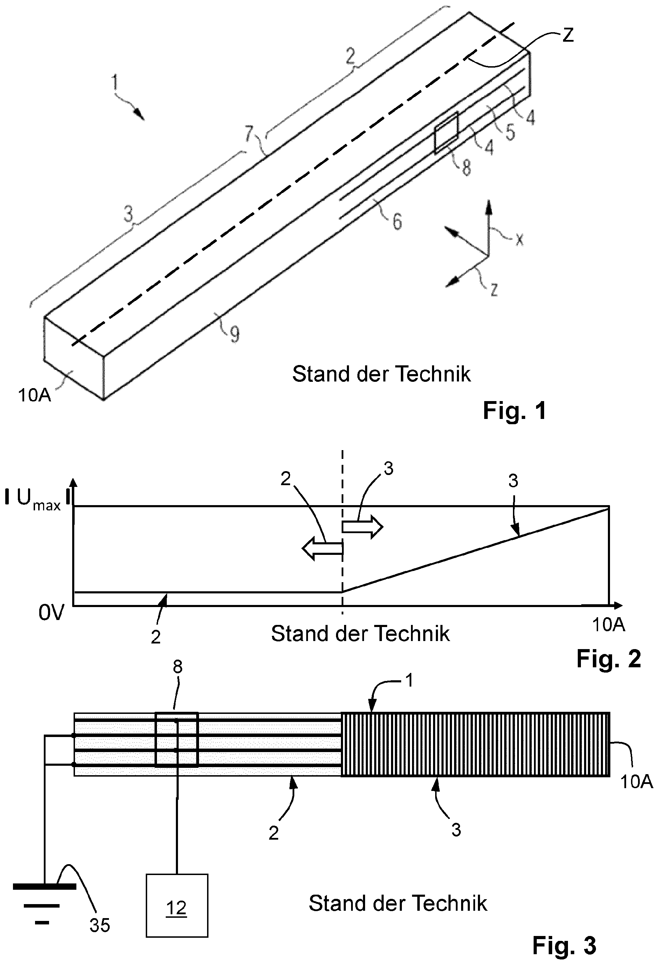

**Figur 1** zeigt einen piezoelektrischen Transformator 1 in einer perspektivischen Ansicht. Der piezoelektrische Transformator 1 kann, gemäß einer möglichen Ausführungsform bei einer Vorrichtung zur Erzeugung von nichtthermischem Atmosphärendruck-Plasma P eingesetzt werden. Obwohl sich die nachfolgende Beschreibung auf die zu den verschiedenen Ausführungsformen auf die Erzeugung von nichtthermischem Atmosphärendruck-Plasma P bezieht, soll dies nicht als Beschränkung der Erfindung aufgefasst werden. Mit der erfindungsgemäßen Vorrichtung 1 oder dem erfindungsgemäßen Bauelement 200 kann ebenso eine hohe Spannung oder ein hohes elektrisches Feld erzeugt werden. Als hohe Spannung wird bei Wechselspannung eine Spannung von > 1kV, typischerweise >3kV in vielen Fällen auch >10kV. Als eine große Feldstärke wird eine Feldstärke >1kV/mm erachtet.

Ein piezoelektrischer Transformator 1 ist eine Bauform eines Resonanztransformators, welcher auf Piezoelektrizität basiert und im Gegensatz zu den herkömmlichen magnetischen Transformatoren ein elektromechanisches System darstellt. Der piezoelektrische Transformator 1 ist, beispielsweise, ein Transformator vom Rosen-Typ.

Der piezoelektrische Transformator 1 weist einen Eingangsbereich 2 und einen Ausgangsbereich 3 auf, wobei der Ausgangsbereich 3 sich in einer Längsrichtung Z an den Eingangsbereich 2 anschließt. Im Eingangsbereich 2 weist der piezoelektrische Transformator 1 Elektroden 4 auf, an die eine Wechselspannung angelegt werden kann. Die Elektroden 4 erstrecken sich in der Längsrichtung Z des piezoelektrischen Transformators 1. Die Elektroden 4 sind in einer Stapelrichtung X, die senkrecht zu der Längsrichtung Z ist, abwechselnd mit einem piezoelektrischen Material 5 gestapelt. Das piezoelektrische Material 5 ist dabei in Stapelrichtung X polarisiert.

Die Elektroden 4 sind im Innern des piezoelektrischen Transformators 1 angeordnet und werden auch als Innenelektroden bezeichnet. Der piezoelektrische Transformator 1 weist eine erste Seitenfläche 6 und eine zweite Seitenfläche 7, die der ersten Seitenfläche 6 gegenüberliegt, auf. Auf der ersten Seitenfläche 6 ist eine erste Außenelektrode 8 angeordnet. Auf der zweiten Seitenfläche 7 ist eine zweite Außenelektrode 8 (hier nicht gezeigt) angeordnet. Die innenliegenden Elektroden 4 sind in Stapelrichtung X abwechselnd, entweder mit der ersten Außenelektrode 8 oder der zweiten Außenelektrode 8, elektrisch miteinander verbunden.

**Figur 3** zeigt eine schematische Darstellung einer herkömmlichen Beschaltung des piezoelektrischen Transformators 1. Der Eingangsbereich 2 kann mit einer geringen Wechselspannung durch eine Ansteuerelektronik 12 angesteuert werden, die zwischen den Elektroden 4 (siehe Figur 1) des Eingangsbereichs 2 angelegt wird. Aufgrund des piezoelektrischen Effekts wird die eingangsseitig angelegte Wechselspannung zunächst in eine mechanische Schwingung umgewandelt. Die Frequenz der mechanischen Schwingung ist dabei im Wesentlichen von der Geometrie, dem mechanischen Aufbau sowie dem Material des piezoelektrischen Transformators 1 abhängig. Der Eingangsbereichs 2 des piezoelektrischen Transformators 1 ist an das Erdpotential 35 gelegt.

Der Ausgangsbereich 3 weist piezoelektrisches Material 9 auf und ist frei von innenliegenden Elektroden 4. Das piezoelektrische Material 9 im Ausgangsbereich 3 ist in der Längsrichtung Z polarisiert. Bei dem piezoelektrischen Material 9 des Ausgangsbereichs 3 kann es sich um das gleiche Material, wie bei dem piezoelektrischen Material 5 des Eingangsbereichs 2, handeln, wobei sich die piezoelektrischen Materialien 5 und 9 in ihrer Polarisationsrichtung unterscheiden können. Im Ausgangsbereich 3 ist das piezoelektrische Material 9 zu einer einzigen monolithischen Schicht geformt, die vollständig in der Längsrichtung Z polarisiert. Dabei weist das piezoelektrische Material 9 im Ausgangsbereich 3 nur eine einzige Polarisationsrichtung auf.

Wird an die Elektroden 4 im Eingangsbereich 2 eine Wechselspannung angelegt, so bildet sich innerhalb des piezoelektrischen Materials 5 und 9 eine mechanische Welle aus, die durch den piezoelektrischen Effekt im Ausgangsbereich 3 eine Ausgangsspannung erzeugt. In **Figur 2** ist eine graphische Darstellung der Ausbildung der Hochspannung an der ausgangsseitigen 10A Stirnfläche des Ausgangsbereichs 3 des piezoelektrischen Transformators 1 dargestellt. Wie aus der Darstellung der **Figur 2** zu erkennen ist, wird im Ausgangsbereich 3 somit eine elektrische Spannung erzeugt, die bis zur Stirnfläche 10A des piezoelektrischen Transformators 1 ansteigt. Die elektrische Spannung wird somit zwischen der Stirnfläche 10A und dem Ende der Elektroden 4 des Eingangsbereichs 2 erzeugt. An der ausgangsseitigen Stirnfläche 10A liegt somit eine Hochspannung an. Dabei entsteht auch zwischen der ausgangseitigen Stirnfläche 10A und einer Umgebung des piezoelektrischen Transformators 1 eine hohe Potentialdifferenz, die ausreicht, um ein starkes elektrisches Feld zu erzeugen, dass ein Prozessmedium bzw. die umgebende Luft ionisiert. Ferner ist die Erzeugung von Radikalen, angeregten Molekülen oder Atomen im Plasma möglich.

Auf diese Weise erzeugt der piezoelektrische Transformator 1 hohe elektrische Felder, die in der Lage sind, Gase oder Flüssigkeiten durch elektrische Anregung zu ionisieren. Dabei werden Atome oder Moleküle des jeweiligen Gases bzw. der jeweiligen Flüssigkeit ionisiert und bilden ein Plasma P. Es kommt immer dann zu einer Ionisation, wenn die elektrische Feldstärke an der Oberfläche des piezoelektrischen Transformators 1 die Zündfeldstärke des Plasmas P überschreitet. Als Zündfeldstärke eines Plasmas P wird dabei die Feldstärke bezeichnet, die zur Ionisation der Atome oder Moleküle bzw. zur Erzeugung von Radikalen, angeregten Molekülen oder Atomen erforderlich ist (hier nicht dargestellt).

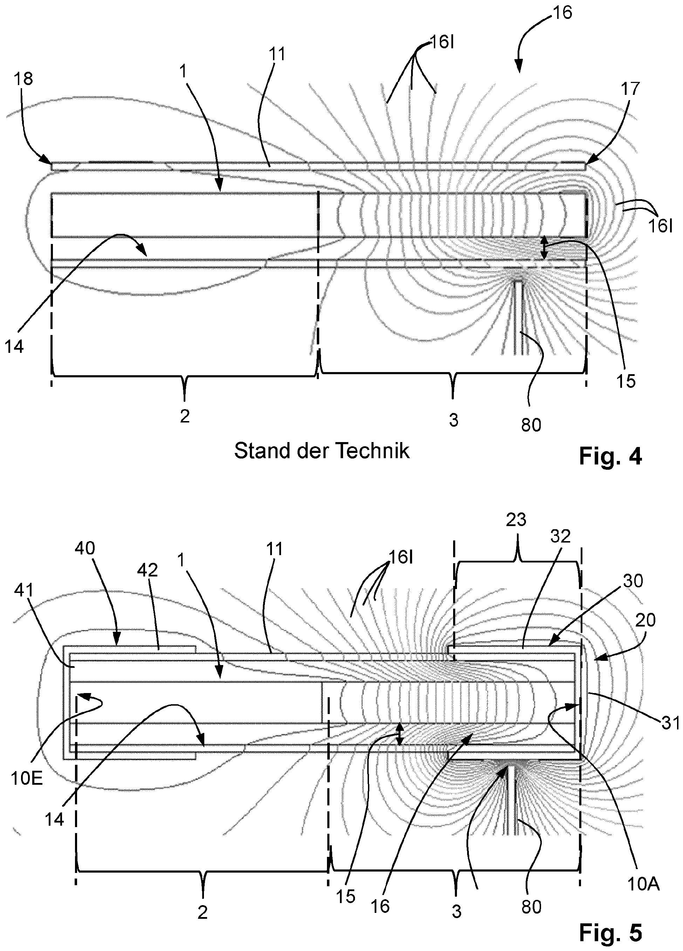

**Figur 4** zeigt eine schematische Darstellung einer Feldverteilung 16 von Isopotentiallinien 16I des elektrischen Feldes bei einem äußeren Einfluss 80 auf die herkömmliche Anordnung des piezoelektrischen Transformators 1. Der piezoelektrische Transformator 1 ist von einer Hülse 11 umgeben, wobei sich der piezoelektrische Transformator 1 mit dem Eingangsbereich 2 und dem Ausgangsbereich 3 entlang seiner Längsrichtung L in der zylinderförmigen, dielektrischen Hülse 11 erstreckt. Durch den äußeren Einfluss 80 werden bei der herkömmlichen Anordnung des piezoelektrischen Transformators 1 die Isopotentiallinien 16I im einen Raum 15 zwischen dem piezoelektrischen Transformator 1 und einer Innenwand 14 der dielektrischen Hülse 11 derart beeinflusst, dass der Abstand zwischen den Isopotentiallinien 16I verringert wird, wodurch die Gefahr besteht, dass die Zündfeldstärke im Raum 15 erreicht wird. Die Zündung des Plasmas im Raum 15 kann zu einer Schädigung des piezoelektrischen Transformators 1 führen.

**Figur 5** ist eine schematische Darstellung der Feldverteilung 16 des elektrischen Feldes bei einem äußeren Einfluss 80 auf die erfindungsgemäße Anordnung des piezoelektrischen Transformators 1 in der zylinderförmigen Hülse 11. Hierzu ist ein Mittel 20, das bei der hier gezeigten Ausführungsform eine topfförmige Kappe 30 ist, die an einem ausgangsseitigen Ende 17 (siehe Figur 4) der zylinderförmigen Hülse 11 abgebracht ist. Die Kappe 30 ist in einem Bereich 23 der zylinderförmigen und dielektrischen Hülse 11 vorgesehen, die sich ausgehend von einer ausgangsseitigen Stirnfläche 10A des piezoelektrischen Transformator 1, zumindest teilweise, in Längsrichtung L entlang des Ausgangsbereichs 3 erstreckt. Die Kappe 30 besteht aus einem Boden 31, der die ausgangsseitige Stirnfläche 10A des piezoelektrischen Transformator 1 abdeckt und einem radial umlaufenden Rand 32, der sich, in Richtung der Längsachse L, entlang des Bereichs 23 erstreckt.

Aus Symmetriegründen und zum Verschluss des Gehäuses 11 kann eine weitere Kappe 40 an einem eingangsseitigen Ende 18 (siehe Figur 4) der zylinderförmigen Hülse 11 abgebracht sein. Die weitere Kappe 40 hat ebenfalls einen radial umlaufenden Rand 42 und einen Boden 41 ausgebildet. Der Boden 41 der weiteren Kappe 40 liegt einer eingangsseitigen Stirnfläche 10E des piezoelektrischen Transformators 1 gegenüber. Die weitere Kappe 40 verschließt das eingangsseitige Ende 18 der zylinderförmigen Hülse 11.

Die Darstellung der Figur 5 zeigt, dass ein äußerer Einfluss 80, der im Bereich 23 an die Hülse 11 angenähert wird, durch das Mittel 20, hier die Kappe 30, zu keiner Verdichtung der Isopotentiallinien 16I im Raum 15 führt. Der Raum 15 liegt im Bereich 23 zwischen dem piezoelektrischen Transformator 1 und einer Innenwand 14 der dielektrischen Hülse 11. Außerhalb der Hülse 11 werden die Isopotentiallinien 16I durch den äußeren Einfluss verdichtet, so dass dort die Zündfeldstärke erreicht wird. Eine Zündung eines Plasmas P in diesem Bereich 23 wirkt sich nicht störend auf den piezoelektrischen Transformator 1 im Innern der Hülse aus (hier nicht dargestellt).

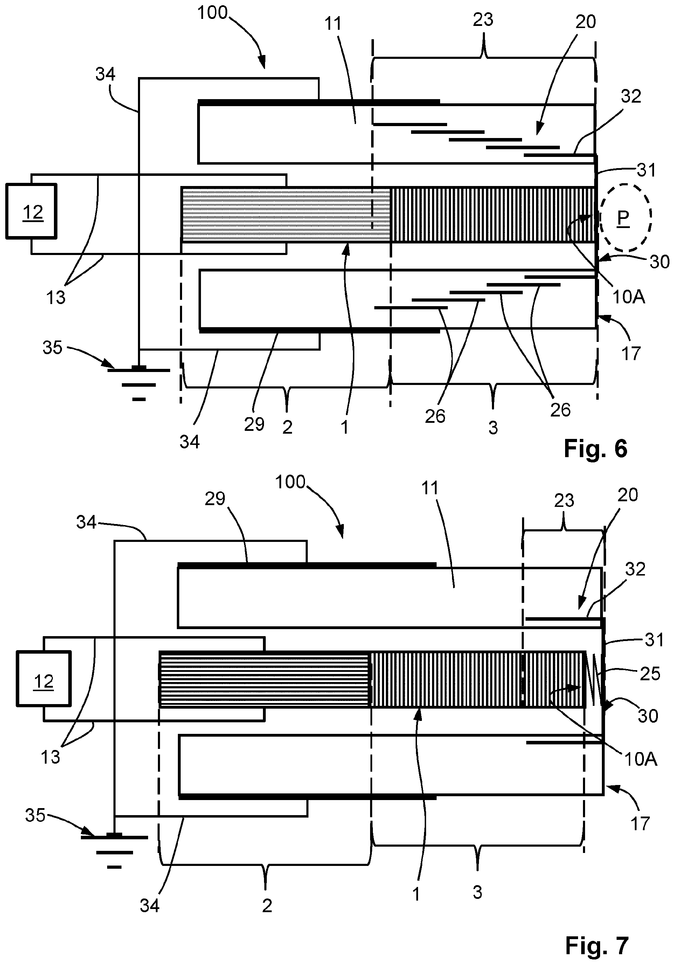

**Figur 6** zeigt eine schematische Darstellung der Vorrichtung 100 zur Erzeugung eines nichtthermischen Atmosphärendruck-Plasmas P. Im Ausgangsbereich 3 der Vorrichtung 100 ist ein Mittel 20 vorgesehen, das zur kapazitiven Feldsteuerung im Ausgangsbereich 3 der Vorrichtung 100 geeignet ist. Wie in den Figuren 6 bis 8 dargestellt, erstreckt sich der piezoelektrische Transformator 1, der einen Eingangsbereich 2 und einen Ausgangsbereich 3 ausgebildet hat, in einer zylinderförmigen, dielektrischen Hülse 11. Der piezoelektrische Transformator 1 ist somit entlang seiner Längsrichtung L von einer zylinderförmigen, dielektrischen Hülse 11 umgeben. Eine Ansteuerelektronik 12 der Vorrichtung 100 ist zur Versorgung des piezoelektrischen Transformators 1 mit Wechselspannung vorgesehen und mit einer Außenelektrode 8 an einer ersten Seitenfläche 6 des Eingangsbereichs 2 (nicht dargestellt) und einer Außenelektrode 8 an einer zweiten Seitenfläche 7 des Eingangsbereichs 2 (nicht dargestellt) über elektrische Leitungen 13 verbunden. Wie bereits in der Beschreibung zu Figur 2 erwähnt, bildet sich an der ausgangsseitigen Stirnfläche 10A des piezoelektrischen Transformator 1 eine Hochspannung aus.

Zur Feldsteuerung ist ein Mittel 20 im Bereich 23 der zylinderförmigen und dielektrischen Hülse 11 vorgesehen. Das Mittel 20 ist derart angeordnet, dass es sich ausgehend von einer ausgangsseitigen Stirnfläche 10A des piezoelektrischen Transformators 1, bei der hier beschriebenen Ausführungsform, in Längsrichtung L entlang des Ausgangsbereichs 3 erstreckt. Bei dieser Ausführungsform umfasst das Mittel 20 eine topfförmige Kappe 30 mit einem Boden 31 und einem radial umlaufenden Rand 32. Der Boden 31 deckt dabei die ausgangsseitige Stirnfläche 10A des piezoelektrischen Transformators 1 ab. Der radial umlaufende Rand 32 erstreckt sich in Richtung der Längsachse L entlang des Bereichs 23. Ferner umfasst bei dieser Ausführungsform das Mittel 20 mehrere kapazitive Elemente 26, die im Bereich 23 der zylinderförmigen Hülse 11 eingebettet sind. Die topfförmige Kappe 30 ist an einem ausgangsseitigen Ende 17 der zylinderförmigen Hülse 11 abgebracht, so dass der radial umlaufende Rand 32 der Kappe 30 im dielektrischen Material der zylinderförmigen Hülse 11 im Bereich 23 eingebettet ist und der Boden 31 der Kappe 30 der ausgangsseitigen Stirnfläche 10A des piezoelektrischen Transformators 1 gegenüber liegt. Die topfförmige Kappe 30 verschließt das ausgangsseitige Ende 17 der zylinderförmigen Hülse 11. Alle der in den Figuren 6 bis 9 dargestellten Ausführungsformen der Vorrichtung 100, tragen an einer Außenwand 19 der zylinderförmigen Hülse 11 eine leitende Umhüllung 29, die zumindest im Eingangsbereich 2 ausgebildet ist (nicht dargestellt). Die leitende Umhüllung 19 liegt über elektrische Leitungen 34 auf Erdpotential 35. Die Ansteuerelektronik 12 ist über eine entsprechende elektrische Leitungen 13 mit den Außenelektroden 8 (hier nicht dargestellt) des Eingangsbereichs 2 des piezoelektrischen Transformators 1 verbunden. Durch die an der ausgangsseitigen Stirnfläche 10A des piezoelektrischen Transformators 1 erzeugten Hochspannung, bildet sich das Plasma P in Längsrichtung L am Boden 31 der Kappe 30 aus.

**Figur 7** zeigt eine schematische Darstellung der Vorrichtung 100 zur Erzeugung eines nichtthermischen Atmosphärendruck Plasmas P, wobei im Ausgangsbereich 3 ein Mittel 20 vorgesehen ist, das zur refraktiven Feldsteuerung geeignet ist. Hierzu besteht das Mittel 20 aus der Hülse 11, die aus einem hochrefraktiven Dielektrikum besteht. Zusätzlich umfasst das Mittel 20 eine topfförmige Kappe 30, die am ausgangsseitigen Ende 17 der zylinderförmigen Hülse 11 abgebracht ist. Der radial umlaufende Rand 32 der Kappe 30 ist im dielektrischen Material der zylinderförmigen Hülse 11 in einem definierten Bereich 23 eingebettet. Der Boden 31 der Kappe 30 ist mit der ausgangsseitigen Stirnfläche 10A des piezoelektrischen Transformators 1 über ein dauerelastisches Element 25 gekoppelt. Die topfförmige Kappe 30 verschließt das ausgangsseitige Ende 17 der zylinderförmigen Hülse 11. Alle anderen Elemente der Vorrichtung 100 sind bereits in der Beschreibung zu Figur 6 erwähnt worden.

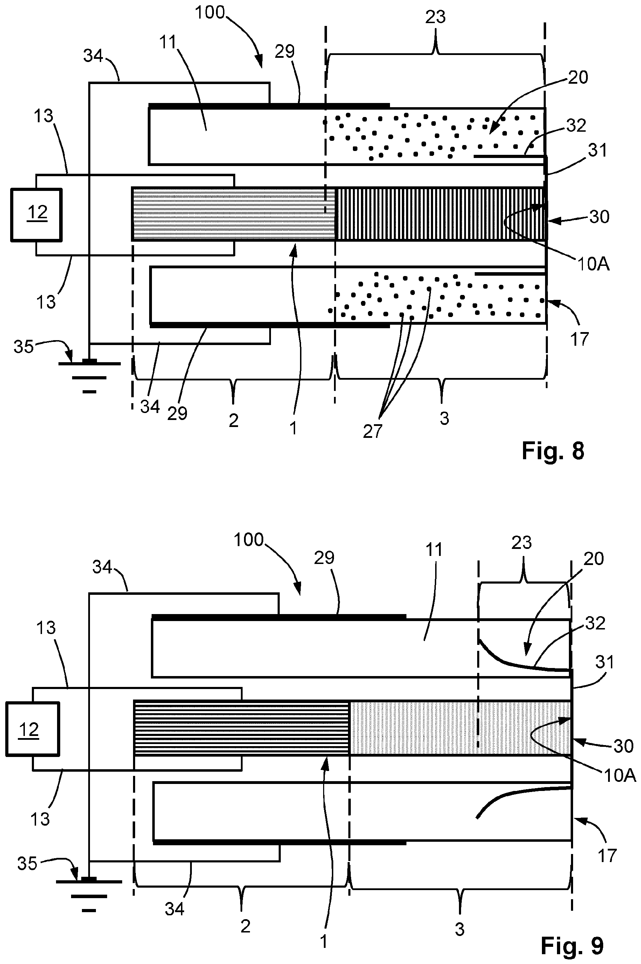

**Figur 8** zeigt eine schematische Darstellung einer weiteren, möglichen Ausführungsform der Vorrichtung 100 zur Erzeugung eines nichtthermischen Atmosphärendruck-Plasmas P. Hierzu ist im Ausgangsbereich 3 ein Mittel 20 vorgesehen, mit dem die Feldverteilung 16 (siehe Figur 5) von Isopotentiallinien 16I des elektrischen Feldes durch einem äußeren Einfluss 80 im Wesentlich konstant gehalten werden kann. Das Mittel 20 bewirkt eine resistive und/oder kapazitive Feldsteuerung, die durch resistive und/oder kapazitive Füller 27 im Material der Hülse 11 im Ausgangsbereich 3 geregelt wird. Die Füllung des Materials der Hülse 11 ist auf dem Bereich 23 beschränkt. Auch hier umfasst das Mittel 20 eine topfförmige Kappe 30, die am ausgangsseitigen Ende 17 der zylinderförmigen Hülse 11 abgebracht ist. Der radial umlaufende Rand 32 der Kappe 30 ist im dielektrischen Material der zylinderförmigen Hülse 11 eingebettet. Der Boden 31 der Kappe 30 liegt der ausgangsseitigen Stirnfläche 10A des piezoelektrischen Transformators 1 gegenüber. Die topfförmige Kappe 30 verschließt das ausgangsseitige Ende 17 der zylinderförmigen Hülse 11.

**Figur 9** zeigt eine schematische Darstellung einer anderen erfindungsgemäßen Ausführungsform der Vorrichtung 100 zur Erzeugung eines nichtthermischen Atmosphärendruck-Plasmas P. Hierzu ist im Ausgangsbereich 3 ein Mittel 20 vorgesehen, das derart gestaltet ist, dass es zu einer geometrischen Feldsteuerung geeignet ist. Bei dieser Ausführungsform ist das Mittel 20 die topfförmige Kappe 30, die am ausgangsseitigen Ende 17 der zylinderförmigen Hülse 11 abgebracht ist. Der radial umlaufende Rand 32 der Kappe 30 ist im dielektrischen Material der zylinderförmigen Hülse 11 im Bereich 23 eingebettet. Der Rand 32 ist derart gestaltet, dass dieser, vom Boden 30 ausgehend, aufgeweitet ist. Auch hier liegt der Boden 31 der Kappe 30 der ausgangsseitigen Stirnseite 10A des piezoelektrischen Transformators 1 gegenüber. Die topfförmige Kappe 30 verschließt das ausgangsseitige Ende 17 der zylinderförmigen Hülse 11.

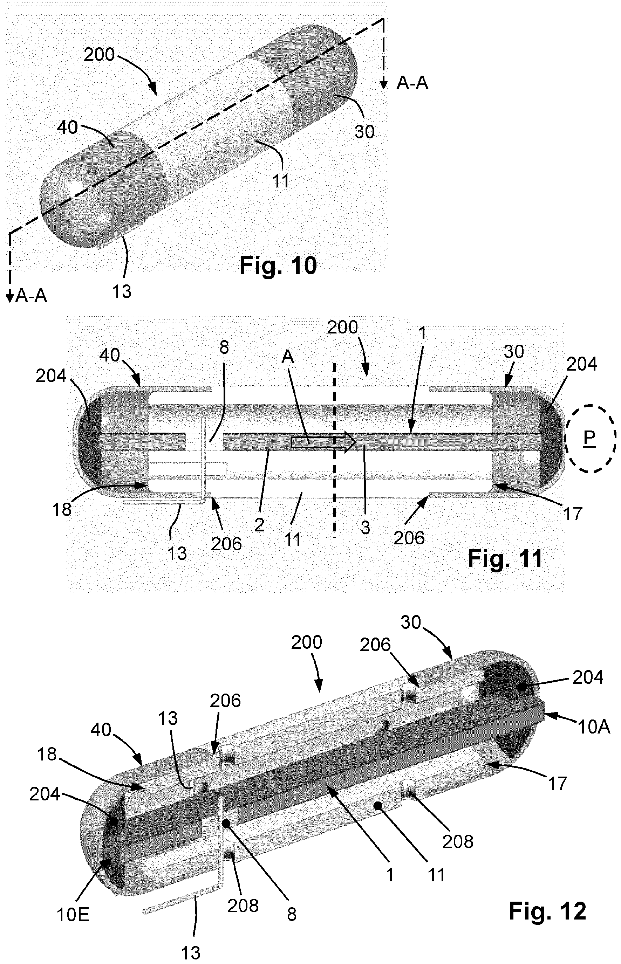

**Figur 10** zeigt eine perspektivische Ansicht eines Bauelements 200 zur Erzeugung eines nichtthermischen Atmosphärendruck-Plasmas P. Das Bauelement 200 kann bei der erfindungsgemäßen Vorrichtung 100 zur Erzeugung eines nichtthermischen Atmosphärendruck-Plasmas P eingesetzt werden. Das Bauelement 200 umfasst eine zylindrische, dielektrische Hülse 11, die von einer Kappe 30 am ausgangsseitigen Ende 17 (hier nicht dargestellt) und von einer weiteren Kappe 40 am eingangsseitigen Ende 18 (hier nicht dargestellt) verschlossen ist. Jeweils eine elektrische Leitung 13 einer jeden Außenelektrode 8 des piezoelektrischen Transformators 1 (siehe Figur 11 und 12) ist durch die dielektrische Hülse 11 des Bauelements 200 nach Außen geführt.

**Figur 11** zeigt eine Schnittansicht des Bauelements 200 zur Erzeugung eines nicht-thermischen Atmosphärendruck-Plasmas P entlang der in Figur 10 gezeigten Schnittlinie A-A. Im Innern der dielektrischen Hülse 11 ist ein piezoelektrischer Transformator 1 angeordnet. Der piezoelektrische Transformator 1 erstreckt sich in axialer Richtung A in der Hülse 202 und ist konzentrisch in der Hülse 11 angeordnet. Der piezoelektrische Transformator 1 ist aus dem Eingangsbereich 2 und dem Ausgangsbereich 3 aufgebaut.

Die Kappe 30 ist am ausgangsseitigen Ende 17 der Hülse 11 angebracht. Die ausgangsseitige Stirnfläche 10A (nicht dargestellt) des piezoelektrischen Transformators 1 liegt an der Kappe 30 an. Die weitere Kappe 40 ist am eingangsseitigen Ende 18 der Hülse 11 angebracht. Die eingangsseitige Stirnfläche 10E (nicht dargestellt) des piezoelektrischen Transformators 1 liegt an der Kappe 40 an. Jede der Außenelektroden 8 des piezoelektrischen Transformators 1 wird von einer elektrischen Leitung 13 kontaktiert. Die elektrischen Leitungen 13 werden aus der Hülse 11 des Bauelements 200 herausgeführt und können von der Ansteuerelektronik 12 (siehe z. B. Figur 6 - 9) kontaktiert werden.

Wie aus der **Figur 11** und der perspektivischen Schnittdarstellung der **Figur 12** des Bauelements 200 zur Erzeugung eines nichtthermischen Atmosphärendruck-Plasmas P ersichtlich ist, ist ein dauerelastisches Element 204 in der Kappe 30 und der weiteren Kappe 40 vorgesehen. Mit dem dauerelastischen Element 204 der Kappe 30 und der weiteren Kappe 40 wird der piezoelektrische Transformator 1 in der Hülse 11 gehaltert. Die ausgangsseitige Stirnfläche 10A des piezoelektrischen Transformators 1 liegt an der Kappe 30 an und die eingangsseitige Stirnfläche 10E des piezoelektrischen Transformators 1 liegt an der weiteren Kappe 40 an.

Wie ebenfalls aus den Figuren 11 und 12, einer bevorzugten Ausführungsform der Erfindung, ersichtlich ist, hat die dielektrische Hülse 11 jeweils beidseitig einen radial umlaufenden Absatz 206. An dem Absatz 206 kann die Kappe 30 bzw. die weitere Kappe 40 angesetzt und somit in eine definierte Position an der Hülse 202 verbracht werden. Die dielektrische Hülse 11 kann, gemäß einer möglichen Ausführungsform, mindestens einen Durchgang 208 in der Hülse 11 ausgebildet haben. Über den Durchgang kann ein Druck-, Temperatur- oder Feuchtigkeitsausgleich zwischen dem Innenraum der Hülse 11 und der Umgebung des Bauelements 200 durchgeführt werden.

Die Kombination der Feldsteuerungsstruktur (zumindest die erste Kappe 30 oder das entsprechend ausgestaltete Mittel 20) mit der mechanischen, z. B. eleatischen Halterung des piezoelektrischen Transformators 1, führen zu einem praktikablen Bauelement 200. Bei dieser Ausführungsform ist der piezoelektrische Transformator 1 mit einem dauerelastischen, elektrisch leitfähigen Element 204 in die Kappe 30 (Feldsteuerungskappe) eingeklebt. Ebenso kann eine Wärmeanbindung des Mittels 20 zur Feldsteuerung bzw. der Kappe 30 vorgesehen sein, um Verlustwärme aus dem piezoelektrischen Transformator 1 abzuführen. Die Kühlung über die Kappe 30 bzw. die weiteren Kappe 40 kann dadurch optimiert werden, wenn die Kappen 30 bzw. 40 als metallische Kappen ausgebildet sind.

Die Kappe 30 (Feldsteuerungsstruktur) und die weitere Kappe 40 dienen zur Kapselung des piezoelektrischen Transformators 1 im der Hülse 11, um einen Staubschutz oder Berührungsschutz zu erreichen. Ferner führen die Kappe 30 oder das Mittel 20 (Feldsteuerungsstruktur) zur Reduzierung der elektromagnetischen Emission.

Die Erfindung wurde in Bezug auf bevorzugte Ausführungsformen beschrieben. Es ist für einen Fachmann jedoch selbstverständlich, dass Änderungen und Abwandlungen gemacht werden können, ohne dabei den Schutzbereich der nachstehenden Schutzansprüche zu verlassen.

### Bezugszeichenliste

- 1: piezoelektrischer Transformator
- 2: Eingangsbereich
- 3: Ausgangsbereich
- 4: Elektrode
- 5: piezoelektrisches Material
- 6: erste Seitenfläche
- 7: zweite Seitenfläche
- 8: Außenelektrode
- 9: piezoelektrisches Material
- 10A: ausgangsseitige Stirnfläche
- 10E: eingangsseitige Stirnfläche
- 11: zylinderförmige Hülse
- 12: Ansteuerelektronik
- 13: elektrische Leitungen
- 14: Innenwand
- 15: Raum
- 16: Feldverteilung
- 16I: Isopotentiallinie
- 17: ausgangsseitiges Ende
- 18: eingangsseitiges Ende
- 19: Außenwand
- 20: Mittel
- 23: Bereich
- 25: dauerelastisches Element
- 26: kapazitive Elemente
- 27: Füller
- 29: leitende Umhüllung
- 30: Kappe
- 31: Boden
- 32: radial umlaufender Rand
- 34: elektrische Leitung
- 35: Erdpotential
- 40: weitere Kappe
- 41: Boden
- 42: radial umlaufender Rand
- 80: äußerer Einfluss
- 100: Vorrichtung
- 200: Bauelement
- 204: dauerelastisches Element
- 206: Absatz
- 208: Durchgang
- A: axiale Richtung
- A-A: Schnittlinie
- P: Plasma
- X: Stapelrichtung
- Z: Längsrichtung

## Patentansprüche

1. Vorrichtung (100) zur Erzeugung einer hohen Spannung oder hohen Feldstärke, umfassend einen piezoelektrischen Transformator (1) mit einem Eingangsbereich (2) und einem Ausgangsbereich (3), eine Ansteuerelektronik (12) ist zur Versorgung des piezoelektrischen Transformators (1) mit Wechselspannung, mit einer Kontaktierung (8) einer ersten Seitenfläche (6) des Eingangsbereichs (2) und einer Kontaktierung (8) einer zweiten Seitenfläche (7) des Eingangsbereichs (2) über elektrische Leitungen (13) verbunden,
**gekennzeichnet durch**
eine zylinderförmige, dielektrische Hülse (11) mit einem ausgangsseitigen Ende (17) und einem eingangsseitigen Ende (18), die den piezoelektrischen Transformator (1) entlang seiner Längsrichtung (L) umgibt; und
ein Mittel (20), das in einem Bereich (23) der zylinderförmigen und dielektrischen Hülse (11), ausgehend von einer ausgangsseitigen Stirnfläche (10A) des piezoelektrischen Transformators (1), vorgesehen ist und sich zumindest teilweise in Längsrichtung (L) entlang des Ausgangsbereichs (3) erstreckt, wobei das Mittel (20) die ausgangsseitige Stirnfläche (10A) des piezoelektrischen Transformators (1) und das ausgangsseitige Ende (17) der zylinderförmigen, dielektrischen Hülse (11) abdeckt und in einem Raum (15) des Bereichs (23), zwischen dem piezoelektrischen Transformator (1) und einer Innenwand (14) der dielektrischen Hülse (11), eine im Wesentlichen symmetrische Feldverteilung (16), auch bei einem äußeren Einfluss, (80) beibehält und eine Feldverteilung (16) derart beeinflusst, dass eine Zündfeldstärke im Raum (15) des Bereichs (23) vermieden ist.

2. Vorrichtung (1) nach Anspruch 1, wobei das Mittel (20) eine topfförmige Kappe (30) mit einem Boden (31) und einem radial umlaufenden Rand (32) ist, wobei der Boden (31) die ausgangsseitige Stirnfläche (10A) des piezoelektrischen Transformators (1) und das ausgangsseitige Ende (17) der zylinderförmigen, dielektrischen Hülse (11) abdeckt und sich der radial umlaufende Rand (32) in Richtung der Längsachse (L) entlang des Bereichs (23) erstreckt.

3. Vorrichtung (1) nach Anspruch 2, wobei die topfförmige Kappe (30) derart an dem ausgangsseitigen Ende (17) der zylinderförmigen Hülse (11) angebracht ist, dass der radial umlaufende Rand (32) der Kappe (30) die zylinderförmige Hülse (11) im Bereich (23) umschließt, und der Boden (31) der Kappe (30) der ausgangsseitigen Stirnfläche (10A) des piezoelektrischen Transformators (1) gegenüber liegt, und die topfförmige Kappe (30) das ausgangsseitige Ende (17) der zylinderförmigen Hülse (11) verschließt.

4. Vorrichtung (1) nach Anspruch 3, wobei eine weitere Kappe (40) an einem eingangsseitigen Ende (18) der zylinderförmigen Hülse (11) angebracht ist, dass ein radial umlaufender Rand (42) der weiteren Kappe (40) die zylinderförmige Hülse (11) umschließt, und ein Boden (41) der weiteren Kappe (40) einer eingangsseitigen Stirnfläche (10E) des piezoelektrischen Transformators (1) gegenüber liegt, und die weitere Kappe (40) das eingangsseitige Ende (18) der zylinderförmigen Hülse (11) verschließt.

5. Vorrichtung (1) nach Anspruch 1, wobei das Mittel (20) eine topfförmige Kappe (30) ist und derart an dem ausgangsseitigen Ende (17) der zylinderförmigen Hülse (11) angebracht ist, dass der radial umlaufende Rand (32) der Kappe (30) im dielektrischen Material der zylinderförmigen Hülse (11) im Bereich (23) eingebettet ist, und der Boden (31) der Kappe (30) der ausgangsseitigen Stirnfläche (10A) des piezoelektrischen Transformators (1) gegenüber liegt, und die topfförmige Kappe (30) das ausgangsseitige, offene Ende (17) der zylinderförmigen Hülse (11) verschließt.

6. Vorrichtung (1) nach Anspruch 1, wobei das Mittel (20) eine topfförmige Kappe (30) mit mehreren kapazitiven Elementen (26) ist, die im Material der zylinderförmigen Hülse (11) im Bereich (23) eingebettet sind, wobei die topfförmige Kappe (30) an dem ausgangsseitigen Ende (17) der zylinderförmigen Hülle (11) angebracht ist, so dass der radial umlaufende Rand (32) der Kappe (30) im dielektrischen Material des zylinderförmigen Gehäuses (11) im Bereich (23) eingebettet ist und der Boden (31) der Kappe (30) der ausgangsseitigen Stirnfläche (10A) des piezoelektrischen Transformators (1) gegenüber liegt, und die topfförmige Kappe (30) das ausgangsseitige Ende (17) der zylinderförmigen Hülse (11) verschließt.

7. Vorrichtung (1) nach Anspruch 1, wobei das Mittel (20) eine topfförmige Kappe (30) ist, die mehrere resistive und/oder kapazitive Füller (27) umfasst, mit denen das Material der zylinderförmigen Hülse (11) im Bereich (23) gefüllt ist, wobei die topfförmige Kappe (30) an einem ausgangsseitigen Ende (17) der zylinderförmigen Hülse (11) angebracht ist, so dass der radial umlaufende Rand (32) der Kappe (30) im dielektrischen Material der zylinderförmigen Hülse (11) im Bereich (23) eingebettet ist und der Boden (31) der Kappe (30) der ausgangsseitigen Stirnfläche (10A) des piezoelektrischen Transformators (1) gegenüber liegt, und die topfförmige Kappe (30) das ausgangsseitige Ende (17) der zylinderförmigen Hülse (11) verschließt.

8. Vorrichtung (1) nach Anspruch 1, wobei das Mittel (20) eine topfförmige Kappe (30) ist, die derart an einem ausgangsseitigen Ende (17) der zylinderförmigen Hülse (11) angebracht ist, dass der radial umlaufende Rand (32) der Kappe (30) im dielektrischen Material der zylinderförmigen Hülse (11) im Bereich (23) eingebettet ist und vom Boden (30) ausgehend aufgeweitet ausgebildet ist und der Boden (30) der Kappe (30) mit der ausgangsseitigen Stirnseite (10A) des piezoelektrischen Transformators (1) über einem dauerelastischen Element (25) gekoppelt ist, und die topfförmige Kappe (30) das ausgangsseitige Ende (17) der zylinderförmigen Hülse (11) verschließt.

9. Vorrichtung (1) nach einem der Ansprüche 5 bis 8, wobei die zylinderförmige Hülse (11) an einer Außenwand (19), zumindest im Eingangsbereich (2), eine leitende Umhüllung (19) aufweist, die auf Erdpotential (35) liegt.

10. Vorrichtung nach einem der vorangehenden Ansprüche, wobei ein Plasma (P), nach dem Mittel (20), auf die ausgangsseitige Stirnfläche (10A) des piezoelektrischen Transformators (1) folgend, außerhalb der zylinderförmigen und dielektrischen Hülse (11) ausbildbar ist.

11. Bauelement (200) gemäß einem der vorgeordneten Ansprüche zur Erzeugung einer hohen Spannung oder hohen Feldstärke, **gekennzeichnet durch** folgende Bauteile:
• eine Kappe (30), die am ausgangsseitigen Ende (17) der Hülse (11) derart angebracht ist, dass die ausgangsseitige Stirnfläche (10A) des piezoelektrischen Transformators (1) an der Kappe (30) anliegt;
• eine weitere Kappe (40) am eingangsseitigen Ende (18) der Hülse (11) derart angebracht ist, dass die eingangsseitige Stirnfläche (10E) des piezoelektrischen Transformators (1) an der weiteren Kappe (40) anliegt; und
• jeweils ein dauerelastisches Element (204), das in der Kappe (30) und der weiteren Kappe (40) vorgesehen ist, in denen der piezoelektrische Transformator (1) gehaltert ist.

12. Bauelement (200) nach Anspruch 11, wobei jeweils eine elektrische Leitung (13) einer jeden Kontaktierung (8) des piezoelektrischen Transformators (1) durch die dielektrische Hülse (11) des Bauelements (200) geführt ist.

13. Bauelement (200) nach einem der Ansprüche 11 bis 12, wobei die dielektrische Hülse (11), jeweils beidseitig, einen radial umlaufenden Absatz (206) ausgebildet hat, an dem die Kappe (30) bzw. die weitere Kappe (40) anliegt und somit eine definierte Positionierung der Kappe (30) bzw. der weiteren Kappe (40) an der Hülse (11) bereitstellt.

14. Bauelement (200) nach einem der Ansprüche 11 bis 13, wobei in der dielektrischen Hülse (11) mindestens ein Durchgang (208) ausgebildet ist, über den ein Druck-, Temperatur- oder Feuchtigkeitsausgleich durchführbar ist.

15. Bauelement (200) nach einem der Ansprüche 11 bis 14, wobei ein Plasma (P) nach der Kappe (30), die am ausgangsseitigen Ende (17) der Hülse (11) sitzt und auf die ausgangsseitige Stirnfläche (10A) des piezoelektrischen Transformators (1) folgt, außerhalb der zylinderförmigen und dielektrischen Hülse (11) ausbildbar ist.

## Claims

1. Device (100) for generating a high voltage or high field strength, comprising a piezoelectric transformer (1) having an input region (2) and an output region (3), a drive electronics (12) for supplying the piezoelectric transformer (1) with alternating voltage, connected to a contact (8) of a first side surface (6) of the input region (2) and to a contact (8) of a second side surface (7) of the input region (2) via electrical lines (13),
**characterized by**
a cylindrical dielectric sleeve (11) having an output-side end (17) and an input-side end (18), which surrounds the piezoelectric transformer (1) along its longitudinal direction (L), and
a means (20) provided in a region (23) of the cylindrical and dielectric sleeve (11) starting from an output-side end face (10A) of the piezoelectric transformer (1) and extending at least partially in the longitudinal direction (L) along the output region (3), wherein the means (20) covers the output-side end face (10A) of the piezoelectric transformer (1) and the output-side end (17) of the cylindrical dielectric sleeve (11), and maintains a substantially symmetrical field distribution (16) in a space (15) of the region (23) between the piezoelectric transformer (1) and an inner wall (14) of the dielectric sleeve (11), even under an external influence (80), and influences a field distribution (16) such that an ignition field strength in the space (15) of the region (23) is avoided.

2. Device (1) according to claim 1, wherein the means (20) is a cup-shaped cap (30) having a bottom (31) and a radially circumferential edge (32), wherein the bottom (31) covers the output-side end face (10A) of the piezoelectric transformer (1) and the output-side end (17) of the cylindrical dielectric sleeve (11), and the radially circumferential edge (32) extends in the direction of the longitudinal axis (L) along the region (23).

3. Device (1) according to claim 2, wherein the cup-shaped cap (30) is attached to the output-side end (17) of the cylindrical sleeve (11) in such a way that the radially circumferential edge (32) of the cap (30) surrounds the cylindrical sleeve (11) in the region (23), and the bottom (31) of the cap (30) is opposite the output-side end face (10A) of the piezoelectric transformer (1), and the cup-shaped cap (30) closes the output-side end (17) of the cylindrical sleeve (11).

4. Device (1) according to claim 3, wherein a further cap (40) is attached to an input-side end (18) of the cylindrical sleeve (11) in such a way that a radially circumferential edge (42) of the further cap (40) surrounds the cylindrical sleeve (11), and a bottom (41) of the further cap (40) is opposite an input-side end face (10E) of the piezoelectric transformer (1), and the further cap (40) closes the input-side end (18) of the cylindrical sleeve (11).

5. Device (1) according to claim 1, wherein the means (20) is a cup-shaped cap (30) and is mounted on the output-side end (17) of the cylindrical sleeve (11) in such a way that the radially circumferential edge (32) of the cap (30) is embedded in the dielectric material of the cylindrical sleeve (11) in the region (23), and the bottom (31) of the cap (30) is opposite the output-side end face (10A) of the piezoelectric transformer (1), and the cup-shaped cap (30) closes the output-side open end (17) of the cylindrical sleeve (11).

6. Device (1) according to claim 1, wherein the means (20) is a cup-shaped cap (30) having a plurality of capacitive elements (26) embedded in the material of the cylindrical sleeve (11) in the region (23), wherein the cup-shaped cap (30) is attached to the output-side end (17) of the cylindrical sleeve (11), so that the radially circumferential edge (32) of the cap (30) is embedded in the dielectric material of the cylindrical sleeve (11) in the region (23), and the bottom (31) of the cap (30) is opposite the output-side end face (10A) of the piezoelectric transformer (1), and the cup-shaped cap (30) closes the output-side end (17) of the cylindrical sleeve (11).

7. Device (1) according to claim 1, wherein the means (20) is a cup-shaped cap (30) comprising a plurality of resistive and/or capacitive fillers (27) with which the material of the cylindrical sleeve (11) in the region (23) is filled, wherein the cup-shaped cap (30) is attached to an output-side end (17) of the cylindrical sleeve (11), so that the radially circumferential edge (32) of the cap (30) is embedded in the dielectric material of the cylindrical sleeve (11) in the region (23), and the bottom (31) of the cap (30) is opposite the output-side end face (10A) of the piezoelectric transformer (1), and the cup-shaped cap (30) closes the output-side end (17) of the cylindrical sleeve (11).

8. Device (1) according to claim 1, wherein the means (20) is a cup-shaped cap (30) which is attached to an outlet-side end (17) of the cylindrical sleeve (11) in such a way that the radially circumferential edge (32) of the cap (30) is embedded in the dielectric material of the cylindrical sleeve (11) in the region (23) and is designed to be widened starting from the bottom (30), and the bottom (30) of the cap (30) is coupled to the output-side end face (10A) of the piezoelectric transformer (1) via a permanently elastic element (25), and the cup-shaped cap (30) closes the output-side end (17) of the cylindrical sleeve (11).

9. Device (1) according to any one of claims 5 to 8, wherein the cylindrical sleeve (11) has on an outer wall (19), at least in the input region (2), a conductive sheath (19) which is at a ground potential (35).

10. Device according to any one of the preceding claims, wherein a plasma (P), after the means (20), following the output-side end face (10A) of the piezoelectric transformer (1), can be formed outside the cylindrical and dielectric sleeve (11).

11. Component (200) according to any one of the preceding claims for generating a high voltage or high field strength, **characterized by** the following components:
a cap (30) attached to the output-side end (17) of the sleeve (11) such that the output-side end face (10A) of the piezoelectric transformer (1) abuts the cap (30);
a further cap (40) attached to the input-side end (18) of the sleeve (11) such that the input-side end face (10E) of the piezoelectric transformer (1) abuts the further cap (40); and
in each case a permanently elastic element (204) provided in the cap (30) and the further cap (40) in which the piezoelectric transformer (1) is held.

12. Component (200) according to claim 11, wherein a respective electrical line (13) of each contact (8) of the piezoelectric transformer (1) is guided through the dielectric sleeve (11) of the component (200).

13. Component (200) according to any one of claims 11 to 12, wherein the dielectric sleeve (11) has formed, in each case on both sides, a radially circumferential shoulder (206) against which the cap (30) or the further cap (40) rests and thus provides a defined positioning of the cap (30) or the further cap (40) on the sleeve (11).

14. Component (200) according to any one of claims 11 to 13, wherein at least one passage (208) is formed in the dielectric sleeve (11), via which a pressure compensation, a temperature compensation or a humidity compensation can be performed.

15. Component (200) according to any one of claims 11 to 14, wherein a plasma (P) can be formed outside the cylindrical and dielectric sleeve (11) after the cap (30), which is seated at the output-side end (17) of the sleeve (11) and follows the output end face (10A) of the piezoelectric transformer (1).

## Revendications

1. Dispositif (100) pour produire une tension élevée ou une intensité de champ élevée, comprenant un transformateur piézoélectrique (1) avec une zone d'entrée (2) et une zone de sortie (3), une électronique de commande (12) étant reliée à un contact (8) d'une première surface latérale (6) de la zone d'entrée (2) et à un contact (8) d'une deuxième surface latérale (7) de la zone d'entrée (2) par des lignes électriques (13) pour alimenter le transformateur piézoélectrique (1) en tension alternative,
**caractérisé par**
un manchon diélectrique cylindrique (11) ayant une extrémité côté sortie (17) et une extrémité côté entrée (18), qui entoure le transformateur piézoélectrique (1) le long de sa direction longitudinale (L) ; et
un moyen (20) qui est prévu dans une zone (23) du manchon cylindrique et diélectrique (11), à partir d'une face frontale côté sortie (10A) du transformateur piézoélectrique (1), et qui s'étend au moins partiellement dans la direction longitudinale (L) le long de la zone de sortie (3), le moyen (20) recouvrant la face frontale côté sortie (10A) du transformateur piézoélectrique (1) et l'extrémité côté sortie (17) du manchon cylindrique et diélectrique (11), et maintenant dans un espace (15) de la zone (23), entre le transformateur piézoélectrique (1) et une paroi intérieure (14) du manchon diélectrique (11), une répartition de champ (16) sensiblement symétrique, même en cas d'influence extérieure (80), et influençant une répartition de champ (16) de manière à éviter une intensité de champ d'allumage dans l'espace (15) de la zone (23).

2. Dispositif (1) selon la revendication 1, dans lequel le moyen (20) est une coiffe en forme de pot (30) avec un fond (31) et un bord radialement périphérique (32), le fond (31) recouvrant la face frontale côté sortie (10A) du transformateur piézoélectrique (1) et l'extrémité côté sortie (17) du manchon diélectrique cylindrique (11), et le bord radialement périphérique (32) s'étendant dans la direction de l'axe longitudinal (L) le long de la zone (23).

3. Dispositif (1) selon la revendication 2, dans lequel la coiffe en forme de pot (30) est montée à l'extrémité côté sortie (17) du manchon cylindrique (11) de telle sorte que le bord radialement périphérique (32) de la coiffe (30) entoure le manchon cylindrique (11) dans la zone (23), que le fond (31) de la coiffe (30) se trouve en face de la face frontale côté sortie (10A) du transformateur piézoélectrique (1) et que la coiffe en forme de pot (30) ferme l'extrémité côté sortie (17) du manchon cylindrique (11).

4. Dispositif (1) selon la revendication 3, dans lequel une autre coiffe (40) est montée à une extrémité côté entrée (18) du manchon cylindrique (11) de telle sorte qu'un bord radialement périphérique (42) de l'autre coiffe (40) entoure le manchon cylindrique (11), qu'un fond (41) de l'autre coiffe (40) se trouve en face d'une face frontale côté entrée (10E) du transformateur piézoélectrique (1) et que l'autre coiffe (40) ferme l'extrémité côté entrée (18) du manchon cylindrique (11).

5. Dispositif (1) selon la revendication 1, dans lequel le moyen (20) est une coiffe en forme de pot (30) et est monté à l'extrémité côté sortie (17) du manchon cylindrique (11) de telle sorte que le bord radialement périphérique (32) de la coiffe (30) soit noyé dans le matériau diélectrique du manchon cylindrique (11) dans la zone (23), que le fond (31) de la coiffe (30) se trouve en face de la face frontale côté sortie (10A) du transformateur piézoélectrique (1) et que la coiffe en forme de pot (30) ferme l'extrémité ouverte côté sortie (17) du manchon cylindrique (11).

6. Dispositif (1) selon la revendication 1, dans lequel le moyen (20) est une coiffe en forme de pot (30) avec plusieurs éléments capacitifs (26) qui sont noyés dans le matériau du manchon cylindrique (11) dans la zone (23), dans lequel la coiffe en forme de pot (30) est montée à l'extrémité côté sortie (17) du manchon cylindrique (11) de telle sorte que le bord radialement périphérique (32) de la coiffe (30) soit noyé dans le matériau diélectrique du manchon cylindrique (11) dans la zone (23), que le fond (31) de la coiffe (30) se trouve en face de la face frontale côté sortie (10A) du transformateur piézoélectrique (1), et que la coiffe en forme de pot (30) ferme l'extrémité côté sortie (17) du manchon cylindrique (11).

7. Dispositif (1) selon la revendication 1, dans lequel le moyen (20) est une coiffe en forme de pot (30) qui comprend plusieurs matières de remplissage résistives et/ou capacitives (27) avec lesquelles le matériau du manchon cylindrique (11) est rempli dans la zone (23), dans lequel la coiffe en forme de pot (30) est montée à une extrémité côté sortie (17) du manchon cylindrique (11) de telle sorte que le bord radialement périphérique (32) de la coiffe (30) soit noyé dans le matériau diélectrique du manchon cylindrique (11) dans la zone (23), que le fond (31) de la coiffe (30) se trouve en face de la face frontale côté sortie (10A) du transformateur piézoélectrique (1), et que la coiffe en forme de pot (30) ferme l'extrémité côté sortie (17) du manchon cylindrique (11).

8. Dispositif (1) selon la revendication 1, dans lequel le moyen (20) est une coiffe en forme de pot (30) qui est montée à une extrémité côté sortie (17) du manchon cylindrique (11) de telle sorte que le bord radialement périphérique (32) de la coiffe (30) soit noyé dans le matériau diélectrique du manchon cylindrique (11) dans la zone (23) et soit réalisé de manière élargie à partir du fond (30), que le fond (30) de la coiffe (30) soit accouplé à la face frontale côté sortie (10A) du transformateur piézoélectrique (1) par l'intermédiaire d'un élément à élasticité permanente (25), et que la coiffe en forme de pot (30) ferme l'extrémité côté sortie (17) du manchon cylindrique (11).

9. Dispositif (1) selon l'une des revendications 5 à 8, dans lequel le manchon cylindrique (11) présente sur une paroi extérieure (19), au moins dans la zone d'entrée (2), une enveloppe conductrice (19) qui est au potentiel de terre (35).

10. Dispositif selon l'une des revendications précédentes, dans lequel un plasma (P) peut être formé à l'extérieur du manchon cylindrique et diélectrique (11), en aval du moyen (20), à la suite de la face frontale côté sortie (10A) du transformateur piézoélectrique (1).

11. Élément (200) selon l'une des revendications précédentes pour produire une tension élevée ou une intensité de champ élevée, **caractérisé par** les composants suivants :
une coiffe (30) qui est montée à l'extrémité côté sortie (17) du manchon (11) de telle sorte que la face frontale côté sortie (10A) du transformateur piézoélectrique (1) soit appliquée contre la coiffe (30) ;
une autre coiffe (40) qui est montée à l'extrémité côté entrée (18) du manchon (11) de telle sorte que la face frontale côté entrée (10E) du transformateur piézoélectrique (1) soit appliquée contre l'autre coiffe (40) ; et
un élément à élasticité permanente (204) qui est prévu dans chacune de la coiffe (30) et de l'autre coiffe (40), dans lesquels le transformateur piézoélectrique (1) est maintenu.

12. Élément (200) selon la revendication 11, dans lequel un conducteur électrique (13) de chaque contact (8) du transformateur piézoélectrique (1) est guidé à travers le manchon diélectrique (11) de l'élément (200).

13. Élément (200) selon l'une des revendications 11 à 12, dans lequel le manchon diélectrique (11) présente, des deux côtés, un épaulement radialement périphérique (206) contre lequel la coiffe (30), respectivement l'autre coiffe (40), s'applique et permet ainsi un positionnement défini de la coiffe (30), respectivement de l'autre coiffe (40), sur le manchon (11).

14. Élément (200) selon l'une des revendications 11 à 13, dans lequel au moins un passage (208) est formé dans le manchon diélectrique (11), par lequel une compensation de pression, de température ou d'humidité peut être réalisée.

15. Élément (200) selon l'une des revendications 11 à 14, dans lequel un plasma (P) peut être formé à l'extérieur du manchon cylindrique et diélectrique (11), en aval de la coiffe (30) qui est située à l'extrémité côté sortie (17) du manchon (11) et fait suite à la face frontale côté sortie (10A) du transformateur piézoélectrique (1).
